Europäisches Patentamt

European Patent Office

Office européen des brevets

(19)

(11) Veröffentlichungsnummer : **0 596 895 B1**

(12) **EUROPÄISCHE PATENTSCHRIFT**

(45) Veröffentlichungstag der Patentschrift :
**08.11.95 Patentblatt 95/45**

(51) Int. Cl.$^6$ : **G01R 31/08**

(21) Anmeldenummer : **92912759.5**

(22) Anmeldetag : **16.06.92**

(86) Internationale Anmeldenummer :
**PCT/EP92/01363**

(87) Internationale Veröffentlichungsnummer :
**WO 93/03389 18.02.93 Gazette 93/05**

(54) **VERFAHREN UND EINRICHTUNG ZUR ELEKTRISCHEN KURZSCHLUSSPRÜFUNG UND -ORTUNG FÜR LEITUNGEN, INSBESONDERE FÜR FAHRLEITUNGEN ELEKTRISCHER BAHNEN.**

(30) Priorität : **01.08.91 DE 4125446**

(43) Veröffentlichungstag der Anmeldung :
**18.05.94 Patentblatt 94/20**

(45) Bekanntmachung des Hinweises auf die
Patenterteilung :
**08.11.95 Patentblatt 95/45**

(84) Benannte Vertragsstaaten :
**DE**

(56) Entgegenhaltungen :
**DE-A- 3 110 119**
**FR-A- 2 485 741**
**GB-A- 2 036 478**
**US-A- 3 728 620**

(73) Patentinhaber : **SIEMENS AKTIENGESELLSCHAFT**
**Wittelsbacherplatz 2**
**D-80333 München (DE)**

(72) Erfinder : **BEHMANN, Uwe**
**Otto-Hahn-Str. 7**
**D-6670 St. Ingbert (DE)**

EP 0 596 895 B1

EP 0 596 895 B1

## Beschreibung

Die Erfindung betrifft ein Verfahren und eine Einrichtung zur elektrischen Kurzschlußprüfung und -ortung für Leitungen. Sie soll insbesondere auf Speiseleitungen und Fahrleitungen, also Oberleitungen und Stromschienen, von elektrischen Bahnen und Obussen anwendbar sein. Sie kann aber auch für andere Leitungen, z.B. solche von Hochspannungsgleichstromübertragungen, eingesetzt werden.

Die elektrische Kurzschlußprüfung soll nach kurzschlußbedingter Ausschaltung einer elektrischen Leitung dem Netzbetriebsführungspersonal eine Information darüber geben, ob es sich um einen vorübergehenden Kurzschluß (sog."Wischer") handelte oder ob der Kurzschluß fortbesteht (sog."Dauerkurzschluß"). Bei einem Dauerkurzschluß auf einer Fahrleitung einer elektrischen Bahn muß im allgemeinen damit gerechnet werden, daß der Regellichtraum der Bahn eingeschränkt ist, sich also ein Hindernis im Fahrweg der Bahn befindet.

Wünschenswert wäre in diesem Falle eine elektrische Kurzschlußortung, die dem Betriebsführungspersonal eine möglichst schnelle und möglichst genaue Information darüber liefert, an welcher Stelle der Kurzschluß und damit Gefahr für Züge besteht. Zugleich sollte der kurzschlußbehaftete Fahrleitungsabschnitt identifiziert werden können, damit er elektrisch abgetrennt und der übrige Speisebezirk wieder eingeschaltet werden kann.

Es ist bekannt, daß zur elektrischen Kurzschlußprüfung von Leitungen die Netzspannung einmal wieder direkt zugeschaltet wird. Dieses Wiederzuschalten beinhaltet das Risiko eines erneuten Kurzschlusses mit allen seinen Gefahren und erlaubt keine Kurzschlußortung.

Es ist auch bekannt, daß vielfach zur elektrischen Kurzschlußprüfung von Fahrleitungen die Netzspannung über einen ohmschen Widerstand aufgeschaltet wird und aus den Werten der elektrischen Größen an diesem Vorwiderstand gefolgert wird, ob der Kurzschluß noch weiter besteht oder nicht. Dieses Verfahren liefert nicht immer eindeutige Ergebnisse, weil Kurzschlußstellen in Fahrleitungsnetzen elektrischer Bahnen oft Übergangswiderstände haben, insbesondere wenn Bäume die Fahrleitungen berühren.

Es ist ferner bekannt, daß zur elektrischen Kurzschlußortung, insbesondere bei Wechselstrombahnen, entlang der Fahrleitung Stromwandler oder Spannungswandler eingebaut sind, teilweise mit unmittelbar nachgeschalteten Relais, die bei bestimmten Grenzwerten von Stromstärke oder Spannung ansprechen oder abfallen. Die Ausgangsgrößen dieser Wandler oder die Stellungsanzeigen solcher Relais erlauben dann gewisse Rückschlüsse auf den ungefähren Kurzschlußbereich. Diese Wandler, Relais und zugehörigen Fernübertragungseinrichtungen sind technisch aufwendig. Die Stromwandler können nicht selektiv geschützt werden und sind deshalb potentielle Dauerkurzschlußstellen. Es können damit auch nicht immer und überall Kurzschlußstromstärken von Betriebsstromstärken zuverlässig unterschieden werden, weil erstere häufig durch Übergangswiderstände beeinflußt werden. Eine genaue Kurzschlußortung ist damit nicht möglich, weil die Wandler nur an einzelnen Punkten des Fahrleitungsnetzes, nämlich nur in den Bahnhöfen und an sonstigen Betriebsstellen eingebaut sind und die dazwischenliegenden Streckenabschnitte, insbesondere bei Fernbahnen, viele Kilometer lang sind.

Es ist weiter bekannt, daß die elektrische Kurzschlußortung bei Bahnen vielfach so vorgenommen wird, daß bei über den ohmschen Vorwiderstand ständig eingeschalteter Netzspannung vom Netzbetriebsführungspersonal schrittweise einzelne Abschnitte der Fahrleitung elektrisch abgetrennt werden, bis die Anzeigen der elektrischen Größen plötzlich wechseln. Dann war das zuletzt abgeschaltete elektrische Anlageteil das kurzschlußbehaftete. Die Zeit, in der dieses Verfahren zum Erfolg führt, hängt sehr stark von der Streckenausrüstung mit Fernsteuerung, von den Reaktionen des Netzbetriebsführungspersonals und vom Zufall ab. Der Vorgang kann mehrere Minuten dauern, während deren die Gefahr an der Strecke fortbesteht. Eine genaue Kurzschlußortung ist dabei nicht möglich, weil die Schalter im Fahrleitungsnetz nur in größeren Abständen, nämlich in den Bahnhöfen und an sonstigen Betriebsstellen eingebaut sind und die dazwischenliegenden Streckenabschnitte, insbesondere bei Fernbahnen, viele Kilometer lang sind.

Es ist schließlich bekannt, daß bei rechnerunterstützten Netzbetriebsführungsstellen von Bahnen Suchprogramme eingesetzt werden, die das schrittweise Auftrennen des Fahrleitungsnetzes automatisch steuern. Solche Suchprogramme bedeuten erheblichen Softwareaufwand. Insbesondere die Laufzeiten der elektromotorischen Schalterantriebe bleiben hierbei unverändert, während deren die Gefahr an der Strecke fortbesteht. Der Kurzschlußort kann auch hierbei nicht genauer bestimmt werden als bis auf ganze, insbesondere bei Fernbahnen viele Kilometer lange Fahrleitungsabschnitte zwischen zwei Schaltern.

Der Erfindung liegt die Aufgabe zugrunde, die elektrische Kurzschlußprüfung und -ortung für Leitungen, insbesondere für Fahrleitungen elektrischer Bahnen, mit technisch einfachsten Mitteln optimal rasch und genau durchzuführen.

Die Aufgabe wird erfindungsgemäß mit einem Verfahren gemäß Anspruch 1 bzw. einer Einrichtung gemäß Anspruch 6 gelöst. Die Erfindung beruht auf dem Prinzip elektrischer Schwingkreise und den dafür geltenden elektrotechnischen Gesetzen. Vorteilhafte Ausgestaltungen der Erfindung ergeben sich aus den Ansprüchen

2

2 bis 5 und 7 bis 17.

Bei einem Kurzschluß wird der Schwingkreis durch die elektrischen Parameter der kurzschlußbehafteten Leitung verstimmt. Das Maß der Verstimmung ist ein Maß für die Entfernung des Kurzschlußortes vom Aufstellungsort des Schwingkreises. Die mit der Erfindung erzielten Vorteile bestehen insbesondere darin, daß die elektrische Kurzschlußprüfung ausgeschalteter Leitungen ohne das Risiko eines nochmaligen Kurzschlusses erfolgt und daß das Prüfergebnis bei entsprechender Ausbildung des Schwingkreises nicht vom Übergangswiderstand an der Kurzschlußstelle abhängt oder bei langen Fahrleitungsbezirken nicht durch den kapazitiven Leitungsbelag verfälscht wird. Sie bestehen ferner darin, daß in Fahrleitungsnetzen, insbesondere von Wechselstrombahnen, auf Stromwandler und Spannungswandler zur Kurzschlußortung weitgehend verzichtet werden kann, daß die Kurzschlußortung weitgehend unabhängig vom Betriebsführungspersonal durchgeführt wird, daß bei rechnerunterstützten Fahrleitungsnetz-Betriebsführungsstellen der Softwareaufwand für Kurzschlußortungsprogramme reduziert werden kann, daß das Ortungsergebnis bei entsprechender Ausbildung des Schwingkreises ebenfalls nicht vom Übergangswiderstand an der Kurzschlußstelle abhängt, daß es bei entsprechender Ausbildung (z.B. Anspruch 4) eine Unterscheidung zwischen metallischem Kurzschluß (z.B. gerissene Oberleitung auf den Schienen) und solchem mit Übergangswiderstand (z.B. Baum in der Oberleitung) erlaubt und daß es wesentlich genauer ist als die Länge eines Streckenabschnittes. Sie bestehen auch darin, daß Prüfung und Ortung sogar durchgeführt werden können und Ergebnisse liefern, wenn noch keine Kurzschlußabschaltung erfolgt ist, also beispielsweise vorbeugend bei gefahrdrohender Witterung, um umgestürzte Bäume zu orten. Die Vorteile bestehen schließlich darin, daß das Verunglücken von Eisenbahnzügen an Stellen mit eingeschränktem Regellichtraum verhindert werden kann, was insbesondere für Hochgeschwindigkeitsbahnen vorteilhaft ist, und daß alle nicht kurzschlußbehafteten Fahrleitungsabschnitte sehr schnell wieder mit Netzspannung versorgt werden können.

Um das Ergebnis dieser Prüfungen und Ortungen möglichst rasch und genau zu bekommen und danach entsprechend in geeigneter Weise handeln zu können, werden in einer vorteilhaften Ausgestaltung der Erfindung die an der Einrichtung gemessenen Werte von Spannung und Stromstärken automatisch in einen Rechner (Anspruch 15) eingegeben. Das gleiche geschieht gegebenenfalls mit den Ausgangsgrößen von Stromwandlern oder Spannungswandlern, die im Fahrleitungsnetz angeordnet sind, oder mit den Ansprech- oder Abfallmerkmalen von Relais, die diesen Wandlern unmittelbar nachgeschaltet sind. Nach Auswertung dieser Eingaben anhand gespeicherter elektrischer und anderer Daten der betroffenen Fahrleitung werden von diesem Rechner Informationen ausgegeben, und zwar nach Grobortung erforderlichenfalls solche für Schalthandlungen, die Feinortung ermöglichen. Nach der Ortung werden netzbetriebliche und eisenbahnbetriebliche Informationen ausgegeben. Diese Informationen werden vom Rechner entweder an das Betriebsführungspersonal für das Fahrleitungsnetz und vorteilhafterweise auch an dasjenige für den Fahrbetrieb gegeben, oder sie werden automatisch in Schalterlaufprogramme und in Zugsicherungs- und -beeinflussungssysteme übergeben. Damit die Ergebnisse der Kurzschlußortungen nicht durch veränderten Schaltzustand des Fahrleitungsnetzes, temperaturbedingt veränderten Wirkwiderstand der elektrischen Leiter, erhöhten Wirkwiderstand der Schleifleiter infolge verschleißbedingter Querschnittsminderung und temperatur-oder sonstwie witterungsbedingt veränderte elektrische Leitungsbeläge verfälscht werden, werden nach einer weiteren Ausbildung der Erfindung (Anspruch 16) Abschaltungen und Wiederzuschaltungen von Fahrleitungsabschnitten, Umgebungstemperatur und elektrische Belastung der Fahrleitung und anderer Leiter, periodisch gemessene Verschleißwerte der Schleifleiter und meteorologische Daten, wie insbesondere Luftfeuchte und Erdfeuchte, manuell oder automatisch in den Rechner eingegeben, der daraus intern Korrekturfaktoren bildet. Der Rechner kann in vorteilhafter Weise mit Probemessungen entlang den Leitungen geeicht werden, wodurch örtliche Abweichungen der Leitungsbeläge von Durchschnittswerten korrigiert werden können.

Weitere Vorteile und Einzelheiten der Erfindung ergeben sich aus der nachfolgenden Beschreibung eines bevorzugten Ausführungsbeispiels anhand der Zeichnung und in Verbindung mit den Unteransprüchen. Es zeigen

Figur 1     ein bevorzugtes Ausführungsbeispiel der Erfindung mit einem statischen Umrichter als Quelle zur Erzeugung von sinusförmiger Spannung oder sinusförmigem Strom veränderlicher Frequenz und mit einem Serienschwingkreis,

Figur 2     das Ausführungsbeispiel der Figur 1 in einer ersten Automatisierungsstufe,

Figur 3     das Ausführungsbeispiel der Figur 1 in einer zweiten Automatisierungsstufe und

Figur 4     das Ausführungsbeispiel der Figur 1 in einer dritten Automatisierungsstufe.

Andere Ausführungen sind mit rotierender elektrischer Maschine als Spannungs- oder Stromquelle oder mit Parallelschwingkreis möglich. Die Ankopplung der erfindungsgemäßen Einrichtung kann ständig oder mobil erfolgen.

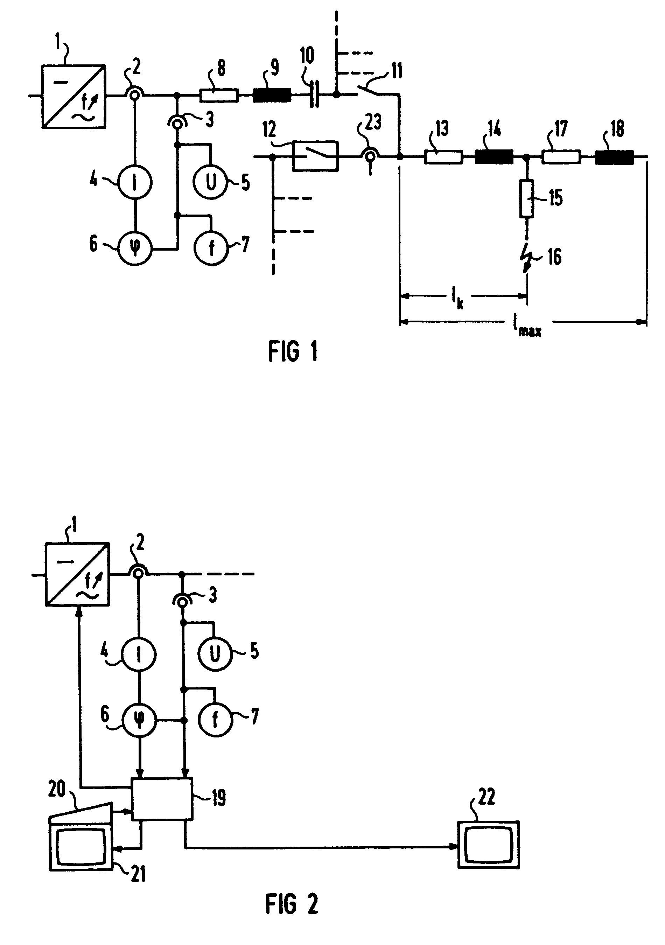

Für das Ausführungsbeispiel in der Figur 1 ist eine kurzschlußbehaftete, zu prüfende Leitung im einpoligen Ersatzschaltbild dargestellt. Sie ist durch ihre resultierenden, annähernd konstanten Leitungsbeläge, nämlich den Längswiderstandsbelag R′ und den Längsinduktivitätsbelag L′ gekennzeichnet. Querkapazitäten und Ableitungswiderstände sind in erster Näherung vernachlässigbar, ebenso die Verlustwiderstände von Schwingkreiskondensator und Schwingkreisdrossel.

In der Figur 1 dient als Quelle zur Erzeugung von Wechselspannung U oder Wechselstrom I veränderlicher Frequenz f ein statischer Umrichter 1. Spannung und Strom sind einphasig. Dem Umrichter 1 sind ein Stromwandler 2 und ein Spannungswandler 3 nachgeschaltet. An die Sekundärwicklungen dieser Wandler sind Strommesser 4, Spannungsmesser 5, Phasenwinkelmesser 6 und Frequenzmesser 7 angeschlossen. Auf die Wandler folgt ein Serienschwingkreis, bestehend aus einer Drosselspule 9 mit der Induktivität $L_o$ und einem Kondensator 10 mit der Kapazität $C_o$. In den Leitungszug des Schwingkreises kann (insb. bei Einsatz einer Konstantspannungsquelle zum Zweck der Vermeidung sehr hoher Resonanzströme bei unterwerksnahem Kurzschluß) noch ein besonderer ohmscher Widerstand 8 mit dem Widerstandswert $R_o$ eingefügt sein.

An die bisher beschriebene Einrichtung kann die zu prüfende Leitung über einen Schalter 11 angeschaltet werden, nachdem sie in ihrem Schaltfeld 12 abgeschaltet worden ist. Die gestrichelten Linien deuten an, daß von der gleichen Anlage aus noch mehrere andere Leitungen abgehen können. Eine kurzschlußbehaftete Leitung hat auf der Länge $l_k$ zwischen dem Speisepunkt (Schalter 11) und dem Kurzschlußort 16 angenähert den längenproportionalen Längswiderstand 13 mit dem Wert $R′ \cdot l_k$ und die längenproportionale Längsinduktivität 14 mit dem Wert $L′ \cdot l_k$. Das Element 15 bedeutet einen Übergangswiderstand $R_k$ an der Kurzschlußstelle. Längswiderstand und -induktivität hinter der Kurzschlußstelle sind in dem Ersatzschaltbild mit den Kennziffern 17 und 18 dargestellt.

Die Wirkungsweise des Ausführungsbeispiels nach Figur 1 ergibt sich wie folgt: Der Serienschwingkreis hat die Eigenfrequenz

$$f_o = \frac{1}{2\pi\sqrt{L_o \cdot C_o}} \; .$$

Wenn er mit einer kurzschlußbehafteten Leitung mit den elektrischen Parametern $R′ \cdot l_k$ und $L′ \cdot l_k$ zusammengeschaltet wird, wird er verstimmt. Seine Eigenfrequenz ändert sich auf den Wert

$$f_k = \frac{1}{2\pi\sqrt{(L_o + L′ \cdot l_k) \cdot C_o}} \; .$$

Ein großer Vorteil ist, daß diese Beziehung frei von allen ohmschen Widerständen ist, also zunächst einem eventuell vorhandenen besonderen ohmschen Widerstand $R_o$ im Serienschwingkreis, ferner sowohl von den Längswiderständen der elektrischen Leiter, gegebenenfalls der Eisenbahnschienen und des Erdreiches, von deren Abhängigkeit von der Frequenz sowie von deren Veränderungen durch Querschnittsverminderung, Temperatur- und Feuchteschwankungen, aber insbesondere von einem Übergangswiderstand $R_k$ an der Kurzschlußstelle. Es ergibt sich damit die Behiehung

$$l_k = \frac{L_o}{L′} \cdot \left(\left(\frac{f_o}{f_k}\right)^2 - 1\right)$$

zwischen der Resonanzfrequenz $f_k$ des Kurzschlußkreises und der Entfernung $l_k$ zwischen Speisepunkt 11 und Kurzschlußort 16.

Die Kurzschlußprüfung und -ortung erfolgt folgendermaßen: Die zu prüfende Leitung wird an die Einrichtung angeschaltet und diese mit einer bestimmten Startfrequenz $f_1$ eingeschaltet, für die gilt

$$f_o \geqq f_1 \geqq \frac{f_o}{\sqrt{1 + \dfrac{L′ \cdot l_{max}}{L_o}}} \; .$$

Aus der Messung, ob überhaupt ein Strom fließt, ergibt sich, ob der Kurzschluß besteht oder nicht. Falls ja, erfolgt die Kurzschlußortung folgendermaßen: Die Frequenz f wird variiert, bis der Phasenwinkel den Wert Null und die Ausgangsgröße des Stromwandlers oder diejenige des Spannungswandlers ein Extremum annehmen, nämlich die Stromstärke ein Maximum oder die Spannung ein Minimum. Aus der zugehörigen Frequenz $f_k$ ist der Kurzschlußort anhand der obigen Funktion $l_k = g(f_k)$ zu identifizieren. Nach dem Ohmschen Gesetz

$$U = I \cdot (R_o + R′ \cdot l_k + R_k)$$

kann danach berechnet werden

$$R_k = \frac{U}{I} - \left(R_o + R′ \cdot \frac{L_o}{L′} \cdot \left[\left(\frac{f_o}{f_k}\right)^2 - 1\right]\right)$$

und daraus auf die Art des Kurzschlusses geschlossen werden, nämlich ob metallisch oder nicht. Das Variieren der Frequenz, das Beobachten und Ablesen von Phasenwinkel und Stromstärke sowie Spannung, das Ablesen der Resonanzfrequenz und ihre Zuordnung zur Kurschlußentfernung sowie schließlich die Berechnung des Ubergangswiderstandes können auf konventionelle Weise vom Netzbetriebsführungspersonal vorgenommen werden. Die Vorgänge können aber auch bis zu beliebigem Grade automatisiert werden, wie im folgenden beschrieben. Soweit dabei zwischen einzelnen Komponenten Umsetzer erforderlich sind, worunter auch Relais verstanden werden sollen, sind diese in den weiteren Figuren nicht besonders dargestellt, ebenso nicht Datenübertragungswege und -einrichtungen.

Bei einer ersten, in Figur 2 dargestellten Automatisierungsstufe wird die Ausgangsfrequenz des Umrichters 1 von einem Rechner 19 gesteuert, der an den ihm eingegebenen Ausgangssignalen der Wandler 2 und 3 den Resonanzfall feststellt, hierfür gemäß den obigen Formeln die Werte für $I_k$ und $R_k$ errechnet und diese ausgibt. Sein zugehöriges Eingabegerät ist mit 20 bezeichnet. In seiner Programmierung ist berücksichtigt, ob und ggf. wie die einzelnen Größen $R_o$, $L_o$, $C_o$, $R'$ und $L'$ frequenzabhängig sind. Bei elektrischen Bahnen enthält er eine Datei, in der den Werten von $I_k$ eisenbahnbetriebliche Bezeichnungen, wie Namen von Bahnhöfen oder sonstigen Betriebsstellen oder zwischen solchen liegenden Streckenabschnitten, zugeordnet sind, aus denen er den oder die zutreffenden herausliest und ausgibt. Diese Ausgabe wird mindestens auf Anzeigegeräte 21 bei örtlichem oder zentralem Netzbetriebsführungspersonal gegeben, kann aber zusätzlich auch direkt auf Anzeigegeräte 22 für die Eisenbahnfahrdienstleiter gegeben werden.

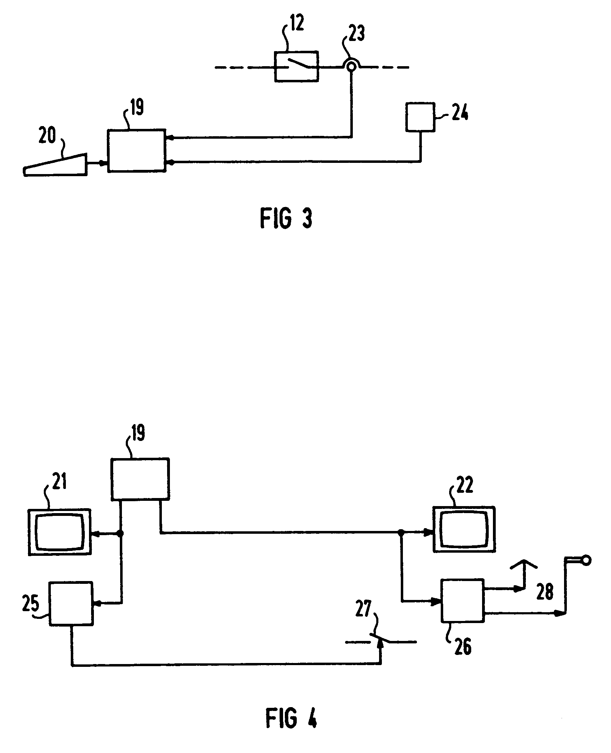

Wenn die Genauigkeit es erfordert, Veränderungen des Längsinduktivitätsbelages $L'$ infolge veränderlichen Leitungsdurchhangs zu berücksichtigen, werden die dafür maßgebenden Einflußgrößen gemäß Figur 3 in den Rechner eingegeben und von diesem verarbeitet. Dies ist hauptsächlich die Leitertemperatur, die entweder direkt, z.B. mittels Thermovision oder indirekt aus kontinuierlichen Messungen von Betriebsstromstärke in der Leitung, und zwar über den Stromwandler 23 des Schaltfeldes, sowie der Werte von Lufttemperatur, Sonnenstrahlungsintensität und Windgeschwindigkeit in einer für die Leitung repräsentativ gelegenen meteorologischen Meßstation 24, deren manuelle oder automatische Eingabe in den Rechner und dortige Korrelation mit den gespeicherten Leitungsdaten ermittelt wird. Soweit die Genauigkeit es erfordert, muß dazu bei elektrischen Bahnen der Querschnittswert der allmählich verschleißenden Schleifleiter von Zeit zu Zeit vom Betriebsführungspersonal über die Rechnereingabe 20 korrigiert werden. Ebenso muß bei Zusatzlasten verfahren werden, soweit es keine automatischen Detektoren dafür gibt. Soweit bei elektrischen Bahnen die Erde als Rückleitung mitbenutzt wird und dabei die Eindringtiefe des Bahnrückstromes und damit der Längsinduktivitätsbelag $L'$ durch die Bodenbeschaffenheit beeinflußt werden, müssen, wenn die Genauigkeit es erfordert, zur Korrektur Werte der Bodenfeuchte, beispielsweise ebenfalls aus der meteorologischen Station, eingegeben werden. Wenn die Genauigkeit es erfordert, bei der Ermittlung des Wertes des Übergangswiderstandes $R_k$ Veränderungen des Wertes von $R'$ durch Erwärmung, Verschleiß und Bodenbeschaffenheit zu berücksichtigen, können dafür die gleichen Eingaben wie für die Korrektur von $L'$ benutzt werden.

In einer weiteren, in Figur 4 dargestellten Automatisierungsstufe gibt der Rechner nicht nur an die Anzeigegeräte 21 und ggf. 22 bei den Betriebsführungspersonalen für das elektrische Netz und für den Fahrdienst aus, sondern auch unmittelbar in die entsprechende Steuerungsanlage 25 für das Fahrleitungsnetz und in diejenige 26 für das Eisenbahnsicherungssystem, die daraufhin automatisch Schalterstellbefehle an Fahrleitungsschalter 27 und Nothaltaufträge 28 an Züge geben.

In einer letzten Automatisierungsstufe wird der Rechner in das gesamte Leittechniksystem des elektrischen Netzes integriert.

## Patentansprüche

1. Verfahren zur elektrischen Kurzschlußprüfung und -ortung bei elektrischen Leitungen, z.B. Fahrleitungen elektrischer Bahnen, bei dem
   a) ein elektrisches Speisesignal (U,I) erzeugt wird, dessen Frequenz (f) veränderbar ist,
   b) dieses elektrische Speisesignal über einen elektrischen Schwingkreis (9,10) auf die Leitung (13 - 18) gegeben wird,
   c) die Frequenz des Speisesignals solange geändert wird, bis das elektrische Signal ein Extremum aufweist und der Phasenwinkel ($\varphi$) Null wird, was ein Kriterium für das Vorliegen eines Kurzschlusses ist, und
   d) aus dem Grad der Verstimmung zwischen der Speisesignalfrequenz ($f_k$) bei Extremum und Phasenwinkel Null und der Eigenfrequenz ($f_o$) auf den Ort ($l_k$) des Kurzschlusses geschlossen wird.

2. Verfahren nach Anspruch 1, bei dem ein Anzeigesignal für das Vorliegen eines Kurzschlusses erzeugt wird, wenn das elektrische Signal ein Extremum aufweist und der Phasenwinkel Null wird.

3. Verfahren nach Anspruch 1 oder 2, bei dem aus dem Grad der Verstimmung zwischen der Speisesignal-frequenz ($f_k$) bei Extremum und Phasenwinkel Null und der Eigenfrequenz ($f_o$) des Schwingkreises ein Anzeigesignal für den Ort ($l_k$) des Kurzschlusses gewonnen wird.

4. Verfahren nach einem der Ansprüche 1 bis 3, bei dem aus den elektrischen Größen ($U,I,R_o,R',L_o,L',f_k,f_o$) des Speisesignals, des Schwingkreises und der elektrischen Leitung bei Extremum und Phasenwinkel Null auf die Art ($R_k$) des Kurzschlusses geschlossen wird.

5. Verfahren nach Anspruch 4, bei dem ein Anzeigesignal für die Art des Kurzschlusses erzeugt wird.

6. Einrichtung zur elektrischen Kurzschlußprüfung und -ortung bei elektrischen Leitungen, z.B. Fahrleitungen elektrischer Bahnen,
   a) mit einer elektrischen Quelle (1), die ein elektrisches Speisesignal (U,I) erzeugt, dessen Frequenz (f) veränderbar ist, und
   b) einem elektrischen Schwingkreis (9,10), über den dieses elektrische Speisesignal auf die Leitung (13 - 18) gegeben wird, wobei
   c) die Frequenz des Speisesignals solange geändert wird, bis das elektrische Signal ein Extremum auf-weist und der Phasenwinkel ($\varphi$) Null wird, was ein Kriterium für das Vorliegen eines Kurzschlusses ist, und
   d) aus dem Grad der Verstimmung zwischen der Speisesignalfrequenz ($f_k$) bei Extremum und Phasen-winkel Null und der Eigenfrequenz ($f_o$) auf den Ort ($l_k$) des Kurzschlusses geschlossen wird.

7. Einrichtung nach Anspruch 6, bei der ein Anzeigesignal für das Vorliegen eines Kurzschlusses erzeugbar ist, wenn das elektrische Signal ein Extremum aufweist und der Phasenwinkel Null wird.

8. Einrichtung nach Anspruch 6 oder 7, bei der aus dem Grad der Verstimmung zwischen der Speisesignal-frequenz ($f_k$) bei Extremum und Phasenwinkel Null und der Eigenfrequenz ($f_o$) des Schwingkreises ein Anzeigesignal für den Ort ($l_k$) des Kurzschlusses ermittelbar ist.

9. Einrichtung nach einem der Ansprüche 6 bis 8, bei der aus den elektrischen Größen ($U,I,R_o,R',L_o,L',f_k,f_o$) des Speisesignals, des Schwingkreises und der elektrischen Leitung bei Extremum und Phasenwinkel Null auf die Art ($R_k$) des Kurzschlusses schließbar ist.

10. Einrichtung nach Anspruch 9, bei der ein Anzeigesignal für die Art des Kurzschlusses erzeugbar ist.

11. Einrichtung nach einem der Ansprüche 6 bis 10, wobei das elektrische Speisesignal eine sinusförmige Wechselspannung ist.

12. Einrichtung nach einem der Ansprüche 6 bis 10, wobei das elektrische Speisesignal ein sinusförmiger Wechselstrom ist.

13. Einrichtung nach einem der Ansprüche 6 bis 12, wobei der elektrische Schwingkreis ein Serienschwingkreis ist.

14. Einrichtung nach einem der Ansprüche 6 bis 13, wobei dem elektrischen Schwingkreis ein ohmscher Widerstand (8) zugeschaltet ist.

15. Einrichtung nach einem der Ansprüche 6 bis 14 mit einem Rechner (19), in dem die signifikanten Größen des Speisesignals, nämlich Spannung (U) und Stromstärke (I), eingegeben und von diesem elektrotechnisch oder sogar unter dem Gesichtspunkt des Eisenbahn- und Netzbetriebs ausgewertet werden.

16. Einrichtung nach Anspruch 15, wobei dem Rechner zur Bildung von Korrekturwerten manuell oder automatisch Schaltzustände des Fahrleitungsnetzes, Belastungswerte der elektrischen Leiter, Verschleißwerte der Schleifleiter und meteorologische Daten eingegeben werden.

17. Einrichtung nach Anspruch 15 oder 16, wobei die Funktionen des Rechners ganz oder teilweise in andere

EP 0 596 895 B1

Schutz- und Leittechniksysteme integriert sind.

**Claims**

1. Method for the electrical testing and location of short-circuits in the case of electric lines, e.g. contact lines of electric railways, wherein
   a) an electric supply signal (U, I) is produced, the frequency (f) of which signal can be altered,
   b) this electric supply signal is transmitted to the line (13 - 18) by way of an electric resonant circuit (9, 10),
   c) the frequency of the supply signal is varied for so long until the electric signal has an extremum and the phase angle ($\varphi$) becomes zero, something which is a criterion for the presence of a short-circuit, and
   d) the location ($l_k$) of the short-circuit is inferred from the degree of off-resonance between the supply signal frequency ($f_k$), in the case of the extremum and zero phase angle, and the natural frequency ($f_o$).

2. Method according to claim 1, wherein an indicator signal for the presence of a short-circuit is produced if the electric signal has an extremum and the phase angle becomes zero.

3. Method according to claim 1 or 2, wherein an indicator signal for the location ($l_k$) of the short-circuit is obtained from the degree of off-resonance between the supply signal frequency ($f_k$), in the case of the extremum and zero phase angle, and the natural frequency ($f_o$) of the resonant circuit.

4. Method according to one of the claims 1 to 3, wherein the type ($R_k$) of short-circuit is inferred from the electric variables (U, I, $R_o$, R', $L_o$, L', $f_k$, $f_o$) of the supply signal, of the resonant circuit and of the electric line in the case of the extremum and zero phase angle.

5. Method according to claim 4, wherein an indicator signal for the type of short-circuit is produced.

6. Device for the electrical testing and location of short-circuits in the case of electric lines, e.g. contact lines of electric railways,
   a) having an electrical source (1), which produces an electric supply signal (U, I), the frequency (f) of which signal can be altered, and
   b) an electric resonant circuit (9, 10), by way of which said electric supply signal is transmitted to the line (13 - 18), wherein
   c) the frequency of the supply signal is varied for so long until the electric signal has an extremum and the phase angle ($\varphi$) becomes zero, something which is a criterion for the presence of a short-circuit, and
   d) the location ($l_k$) of the short-circuit is inferred from the degree of off-resonance between the supply signal frequency ($f_k$), in the case of the extremum and zero phase angle, and the natural frequency ($f_o$).

7. Device according to claim 6, wherein an indicator signal for the presence of a short-circuit can be produced if the electric signal has an extremum and the phase angle becomes zero.

8. Device according to claim 6 or 7, wherein an indicator signal for the location ($l_k$) of the short-circuit can be established from the degree of off-resonance between the supply signal frequency ($f_k$), in the case of the extremum and zero phase angle, and the natural frequency ($f_o$) of the resonant circuit.

9. Device according to one of the claims 6 to 8, wherein the type ($R_k$) of short-circuit can be inferred from the electric variables (U, I, $R_o$, R', $L_o$, L', $f_k$, $f_o$) of the supply signal, of the resonant circuit and of the electric line in the case of the extremum and zero phase angle.

10. Device according to claim 9, wherein an indicator signal for the type of short-circuit can be produced.

11. Device according to one of the claims 6 to 10, wherein the electric supply signal is a sinusoidal alternating voltage.

7

**12.** Device according to one of the claims 6 to 10, wherein the electric supply signal is a sinusoidal alternating current.

**13.** Device according to one of the claims 6 to 12, wherein the electric resonant circuit is a series resonant circuit.

**14.** Device according to one of the claims 6 to 13, wherein an ohmic resistor (8) is connected to the electric resonant circuit.

**15.** Device according to one of the claims 6 to 14, having a computer (19), into which are input the significant variables of the supply signal, namely voltage (U) and current intensity (I), and by which said significant variables are evaluated electrotechnically, or even from the point of view of the railway operation and network operation.

**16.** Device according to claim 15, wherein switching states of the contact-line network, load values of the electric conductors, wear values of the contact conductors and meterological data are input manually or automatically into the computer in order to establish correction values.

**17.** Device according to claim 15 or 16, wherein the functions of the computer are completely or partially integrated into other protection systems and control systems.


**Revendications**

**1.** Procédé pour le contrôle et la localisation de courts-circuits électriques dans des lignes électriques, par exemple des caténaires de chemins de fer électriques, selon lequel
a) un signal électrique d'alimentation (U,I), dont la fréquence (f) peut être modifiée, est produit,
b) ce signal d'alimentation électrique est envoyé dans la ligne (13-18) par l'intermédiaire d'un circuit oscillant électrique (9,10),
c) la fréquence du signal d'alimentation est modifiée jusqu'à ce que le signal électrique atteigne un extremum et que l'angle de phase (j) s'annule, ce qui est un critère de la présence d'un court-circuit, et
d) l'emplacement ($l_k$) de court-circuit est déterminé sur la base du degré de désaccord entre la fréquence ($f_k$) du signal d'alimentation pour l'extremum et l'angle de phase nul et la fréquence propre ($f_o$).

**2.** Procédé suivant la revendication 1, selon lequel un signal indicateur pour la présence d'un court-circuit est produit lorsque le signal électrique possède un extremum et que l'angle de phase s'annule.

**3.** Procédé suivant la revendication 1 ou 2, selon lequel un signal indicateur pour l'emplacement ($l_k$) du court-circuit est obtenu à partir du degré de désaccord entre la fréquence du signal ($f_k$) d'alimentation pour l'extremum et l'angle de phase nul, et la fréquence propre ($f_o$) du circuit oscillant.

**4.** Procédé suivant l'une des revendications 1 à 3, selon lequel le type ($R_k$) du court-circuit est déterminé sur la base des grandeurs électriques ($U,I,R_o,R',L_o,L',f_k,f_o$) du signal d'alimentation, du circuit oscillant de la ligne électrique pour l'extremum et l'angle de phase nul.

**5.** Procédé suivant la revendication 4, selon lequel un signal indicateur est produit pour le type de court-circuit.

**6.** Dispositif pour le contrôle et la localisation de courts-circuits électriques dans des lignes électriques, par exemple des caténaires de voies de chemins de fer électriques, comportant
a) une source électrique (1), qui produit un signal d'alimentation électrique (U,I), dont la fréquence (f) est modifiable, et
b) un circuit oscillant électrique (9,10), par l'intermédiaire duquel ce signal d'alimentation électrique est envoyé à la ligne (13-18),
c) la fréquence du signal d'alimentation étant modifiée jusqu'à ce que le signal électrique atteigne un extremum et que l'angle de phase (j) s'annule, ce qui est un critère de la présence d'un court-circuit, et

d) l'emplacement ($I_k$) de court-circuit étant déterminé sur la base du degré de désaccord entre la fréquence ($f_k$) du signal d'alimentation pour l'extremum et l'angle de phase nul et la fréquence propre ($f_o$).

7. Dispositif suivant la revendication 6, dans lequel un signal indicateur pour la présence d'un court-circuit est produit lorsque le signal électrique possède un extremum et que l'angle de phase s'annule.

8. Dispositif suivant la revendication 6 ou 7, dans lequel un signal indicateur pour l'emplacement ($I_k$) du court-circuit est obtenu à partir du degré de désaccord entre la fréquence du signal ($f_k$) du signal d'alimentation pour l'extremum et l'angle de phase nul, et la fréquence propre ($f_o$) du circuit oscillant.

9. Dispositif suivant l'une des revendications 6 à 8, dans lequel le type ($R_k$) du court-circuit est déterminé sur la base des grandeurs électriques ($U,I,R_o,R',L_o,L',f_k,f_o$) du signal d'alimentation, du circuit oscillant de la ligne électrique pour l'extremum et l'angle de phase nul.

10. Dispositif suivant la revendication 9, dans lequel un signal indicateur peut être produit pour le type de court-circuit.

11. Dispositif suivant l'une des revendications 6 à 10, dans lequel le signal d'alimentation électrique est une tension alternative sinusoïdale.

12. Dispositif suivant l'une des revendications 6 à 10, dans lequel le signal d'alimentation électrique est un courant alternatif sinusoïdal.

13. Dispositif suivant l'une des revendications 6 à 12, dans lequel le circuit oscillant électrique est un circuit oscillant série.

14. Dispositif suivant l'une des revendications 6 à 13, dans lequel une résistance ohmique (8) est raccordée au circuit oscillant électrique.

15. Dispositif suivant l'une des revendications 6 à 14, comportant un calculateur (19), dans lequel des grandeurs importantes du signal d'alimentation, à savoir la tension (U) et l'intensité du courant (I), sont introduites et sont évaluées de façon électronique par ce calculateur ou même du point de vue du fonctionnement des chemins de fer et du fonctionnement du secteur.

16. Dispositif suivant la revendication 15, dans lequel des états de commutation du réseau de caténaires, des valeurs de charge des conducteurs électriques, des valeurs d'usure des conducteurs de contact et des données météorologiques sont introduites manuellement ou de façon automatique dans le calculateur pour la formation de valeurs de correction.

17. Dispositif suivant la revendication 15 ou 16, dans lequel les fonctions du calculateur sont intégrées en totalité ou en partie dans d'autres systèmes techniques de protection et de conduite.

FIG 1

FIG 2

FIG 3

FIG 4